# EUROPEAN PATENT APPLICATION

(11) **EP 4 575 933 A1**
(43) Date of publication of application: **25.06.2025**
(21) Application number: 23383334.2
(22) Date of filing: 20.12.2023
(51) Int. Cl.: G06N 10/80, G06N 20/00

(54) **SYSTEM AND METHODS FOR IMPLEMENTING VARIATIONAL EQUIVARIANT QUANTUM CIRCUITS FOR QUANTUM MACHINE LEARNING AND RELATED METHODS**

(71) Applicant: Multiverse Computing S.L., 20014 Donostia-San Sebastian (ES)
(72) Inventor: ORÚS, Roman, Donostia / San Sebastián (ES); SAN SEBASTIÁN, Paul, Donostia / San Sebastián (ES)
(74) Representative: Balder IP Law, S.L.

(57) **Abstract**

The system and method for implementing symmetric quantum circuits includes a data processing module for processing input data, a quantum circuit construction module for constructing a symmetric quantum circuit on a series of quantum bits using symmetric quantum operations, an optimization module for optimizing circuit parameters using an optimization technique, and an output generation module for generating output data over new input data. The symmetric quantum circuit can be implemented on various quantum hardware and provides faster convergence and training, better precision.

## Description

### TECHNICAL FIELD

The invention pertains to the system and methods for implementing variational equivariant quantum circuits in quantum machine learning. The circuit can be implemented on various quantum hardware and is built using the symmetries of the dataset to be studied. The system includes a data module, an equivariant variational quantum circuit, a classical optimization algorithm, and an inference module.

### BACKGROUND

Quantum machine learning is a rapidly evolving field that leverages the principles of quantum mechanics to improve machine learning algorithms. Quantum circuits, which are the basic units of quantum computation, play a crucial role in this domain. These circuits are built on quantum bits, or qubits, which can exist in multiple states at once, unlike classical bits that can only be in one state at a time. This property of qubits allows quantum circuits to process a vast amount of information simultaneously, potentially leading to faster and more efficient machine learning algorithms. However, designing quantum circuits that can effectively exploit this potential is a challenging task. One of the key challenges is to ensure that the quantum circuits respect the symmetries of the dataset being studied. This is important because symmetries can provide valuable insights into the structure of the data, which can be used to improve the performance of the machine learning algorithm. Another challenge is to optimize the parameters of the quantum circuits to minimize a cost function for a training set. This is typically done using classical optimization algorithms, but these algorithms can be computationally expensive and may not always converge to the optimal solution. Furthermore, once the quantum circuits are trained, they need to be able to make accurate predictions over a new set of data points. This requires an efficient inference mechanism, which is another area of ongoing research in quantum machine learning.

### SUMMARY

In accordance with embodiments, a system is provided for implementing symmetric quantum circuits. The system includes a data processing module for processing input data from a data source, a quantum circuit construction module for constructing a symmetric quantum circuit respecting data characteristics on a series of quantum bits using symmetric quantum operations, an optimization module for optimizing circuit parameters to minimize a performance metric using an optimization technique, and an output generation module for generating output data over new input data. The symmetric quantum circuit provides faster convergence and training, better precision, and can be implemented on various quantum hardware.

In accordance with other embodiments, a method is provided for implementing symmetric quantum circuits. The method involves processing input data from a data source, constructing a symmetric quantum circuit respecting data characteristics on a series of quantum bits using symmetric quantum operations, optimizing circuit parameters to minimize a performance metric using an optimization technique, and generating output data over new input data. The method further includes using the symmetries of the dataset to build the quantum circuit, using a training set for the optimization of the quantum circuit, using a cost function for the optimization of the quantum circuit, using quantum gates in the construction of the quantum circuit, using a series of qubits in the construction of the quantum circuit, and using quantum machine learning in the implementation of the quantum circuits.

### BRIEF DESCRIPTION OF THE DRAWINGS

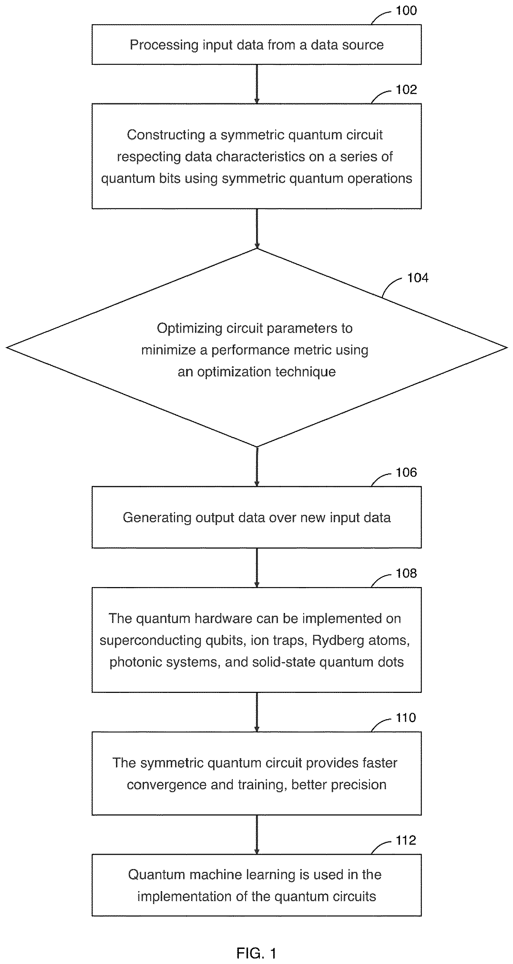

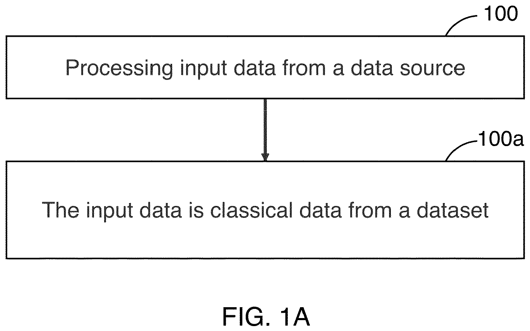

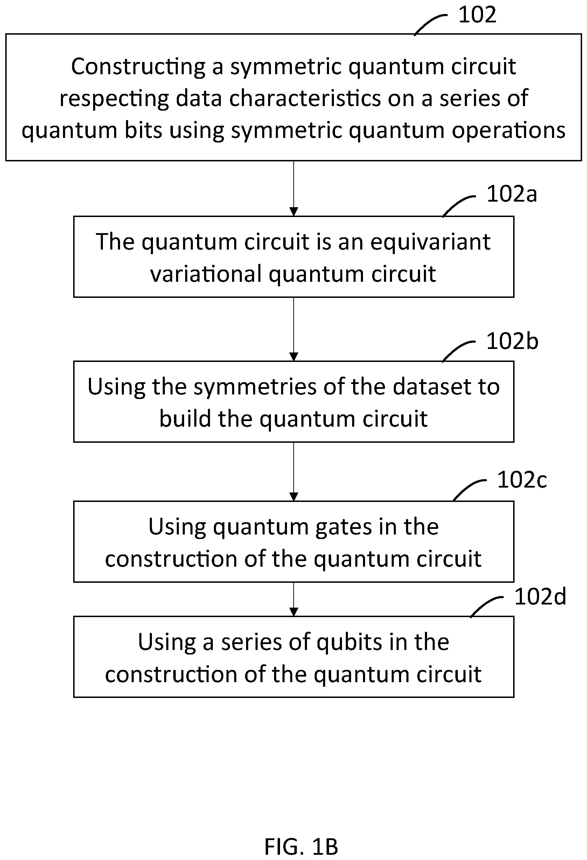

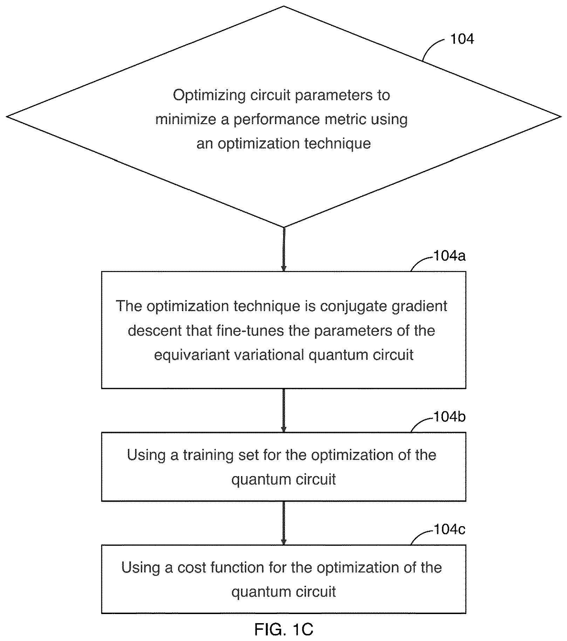

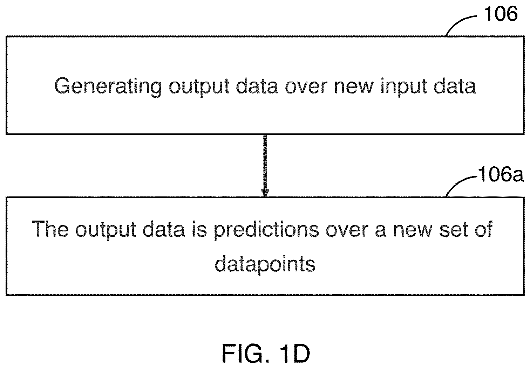

FIG. 1 illustrates, in a flowchart, operations for implementing a symmetric quantum circuit for quantum machine learning in accordance with certain embodiments.
FIG. 1A illustrates, in a flowchart, operations for processing classical data from a data source in accordance with certain embodiments.
FIG. 1B illustrates, in a flowchart, operations for constructing an equivariant variational quantum circuit using the symmetries of the dataset, quantum gates, and a series of qubits in accordance with certain embodiments.
FIG. 1C illustrates, in a flowchart, operations for optimizing the circuit parameters using conjugate gradient descent, a training set, and a cost function in accordance with certain embodiments.
FIG. 1D illustrates, in a flowchart, operations for generating predictions over new input data in accordance with certain embodiments.

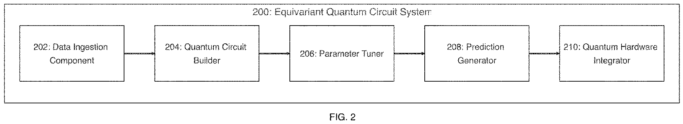

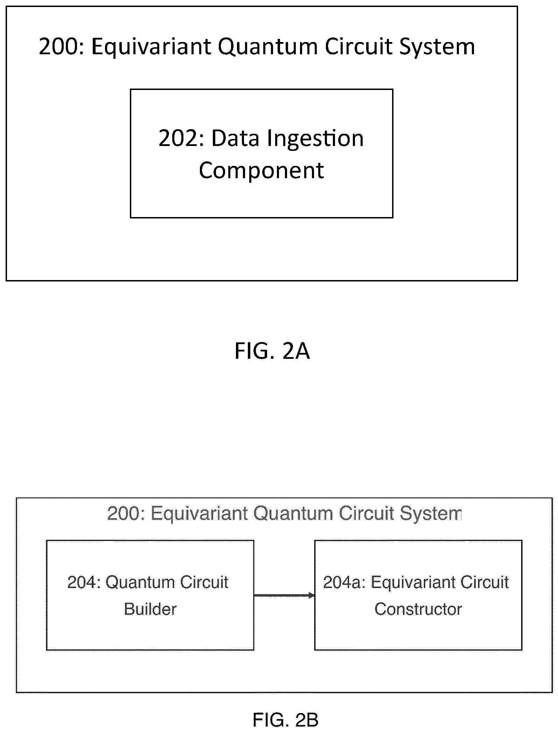

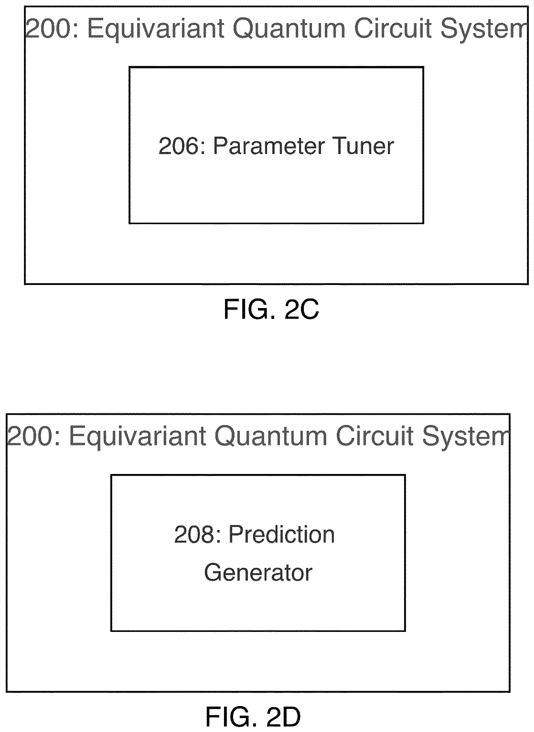

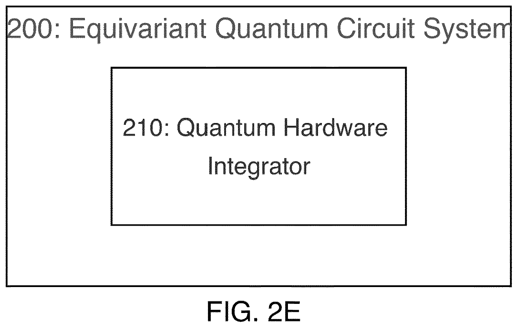

FIG. 2 illustrates, in a block diagram, the main components of an Equivariant Quantum Circuit System in accordance with certain embodiments.
FIG. 2A illustrates, in a block diagram, the Data Ingestion Component of an Equivariant Quantum Circuit System in accordance with certain embodiments.
FIG. 2B illustrates, in a block diagram, the Quantum Circuit Builder and its sub-component, the Equivariant Circuit Constructor, in the Equivariant Quantum Circuit System in accordance with certain embodiments.
FIG. 2C illustrates, in a block diagram, the Parameter Tuner in the Equivariant Quantum Circuit System in accordance with certain embodiments.
FIG. 2D illustrates, in a block diagram, the Prediction Generator in the Equivariant Quantum Circuit System in accordance with certain embodiments.
FIG. 2E illustrates, in a block diagram, the Quantum Hardware Integrator in the Equivariant Quantum Circuit System in accordance with certain embodiments.

### DETAILED DESCRIPTION

Step 100 and its sub-step 100-a from Step 6 involve the processing of input data from a data source. This is manifested as the reading of classical data from a dataset (Claim 9).

The component involved in this action is the data processing module, which can be understood as a part of the quantum computing system designed to handle and process data. In this case, the data is classical data from a dataset, which refers to traditional, non-quantum data that is used as the input for the quantum machine learning process.

The data processing module reads this classical data, which is the initial step in the method of implementing symmetric quantum circuits. This step provides the necessary input data that the rest of the system uses to perform its functions. The data processing module reads the data from a dataset, which can be any collection of data that is relevant to the task at hand.

The reason why the data processing module reads classical data is because this data serves as the basis for the quantum computations that follow. The classical data is used to construct a symmetric quantum circuit, optimize its parameters, and generate output data. Without this input data, the quantum machine learning process cannot begin.

In terms of the mechanism of this action, the data processing module likely uses algorithms and computational processes to read and process the classical data. The specifics of these processes would depend on the nature of the data and the requirements of the specific quantum machine learning task.

In summary, Step 100 and its sub-step 100-a involve the data processing module reading classical data from a dataset, serving as the initial step in the method of implementing symmetric quantum circuits.

Step 102 and its sub-steps from Step 6 involve the construction of a symmetric quantum circuit that respects data characteristics on a series of quantum bits using symmetric quantum operations. This is manifested as the building of an equivariant variational quantum circuit (Claim 10).

The component involved in this action is the quantum circuit construction module. This module is a part of the quantum computing system that is responsible for creating the quantum circuit. The quantum circuit is an equivariant variational quantum circuit, which is a specific type of quantum circuit that respects the symmetries of the dataset.

The quantum circuit construction module builds the quantum circuit using the symmetries of the dataset (Claim 15), quantum gates (Claim 18), and a series of qubits (Claim 19). The symmetries of the dataset are mathematical properties that the quantum circuit is designed to respect. Quantum gates are the basic building blocks of quantum circuits, and they operate on a small number of qubits, which are the fundamental units of quantum information.

The quantum circuit construction module builds the quantum circuit to ensure that the quantum circuit is capable of performing the quantum computations necessary for the quantum machine learning process. The equivariant variational quantum circuit is designed to provide faster convergence and training, and better precision (Claim 14).

In terms of the mechanism of this action, the quantum circuit construction module likely uses quantum algorithms and computational processes to build the quantum circuit. The specifics of these processes would depend on the nature of the symmetries of the dataset, the specific quantum gates used, and the number and arrangement of the qubits.

In summary, Step 102 and its sub-steps involve the quantum circuit construction module building an equivariant variational quantum circuit using the symmetries of the dataset, quantum gates, and a series of qubits. This is a step in the method of implementing symmetric quantum circuits.

Step 104 and its sub-steps from Step 6 involve the optimization of circuit parameters to minimize a performance metric using an optimization technique. This is manifested as the fine-tuning of the parameters of the equivariant variational quantum circuit using conjugate gradient descent or similar (Claim 11).

The component involved in this action is the optimization module. This module is a part of the quantum computing system that is responsible for optimizing the parameters of the quantum circuit. The parameters of the quantum circuit are the variables that determine the behavior of the quantum circuit.

The optimization module fine-tunes the parameters of the quantum circuit using conjugate gradient descent or similar (Claim 11), a training set (Claim 16), and a cost function (Claim 17). Conjugate gradient descent is an optimization algorithm that is used to minimize a cost function, which is a measure of the error or loss of the quantum circuit. The training set is a set of data that is used to adjust the parameters of the quantum circuit.

The optimization module fine-tunes the parameters of the quantum circuit to minimize the cost function and improve the performance of the quantum circuit. The goal is to make the quantum circuit as accurate and efficient as possible in performing the quantum computations.

In terms of the mechanism of this action, the optimization module likely uses mathematical and computational processes to fine-tune the parameters of the quantum circuit. The specifics of these processes would depend on the nature of the parameters, the cost function, and the training set.

In summary, Step 104 and its sub-steps involve the optimization module fine-tuning the parameters of the equivariant variational quantum circuit using conjugate gradient descent or similar, a training set, and a cost function. This is a step in the method of implementing symmetric quantum circuits.

Step 106 and its sub-step from Step 6 involve the generation of output data over new input data. This is manifested as making predictions over a new set of datapoints (Claim 12).

The component involved in this action is the output generation module. This module is a part of the quantum computing system that is responsible for generating the output of the quantum machine learning process. The output data is the result of the quantum computations performed by the quantum circuit and is generated over a new set of datapoints.

The output generation module makes predictions over a new set of datapoints. These predictions are the output data of the quantum machine learning process and are generated based on the optimized parameters of the quantum circuit and the new input data.

The output generation module makes predictions over a new set of datapoints to provide the results of the quantum machine learning process. These results are the predictions made by the quantum circuit based on the new input data.

In terms of the mechanism of this action, the output generation module likely uses quantum algorithms and computational processes to generate the predictions. The specifics of these processes would depend on the nature of the new input data, the optimized parameters of the quantum circuit, and the specific quantum machine learning task.

In summary, Step 106 and its sub-step involve the output generation module making predictions over a new set of datapoints. This is a step in the method of implementing symmetric quantum circuits and provides the results of the quantum machine learning process.

Step 108 from Step 6 involves the implementation of the quantum hardware. This is manifested as the ability to implement the quantum hardware on superconducting qubits, ion traps, Rydberg atoms, photonic systems, and solid-state quantum dots (Claim 13).

The component involved in this action is the quantum hardware. This refers to the physical systems that are used to perform quantum computations. The quantum hardware can be implemented on a variety of systems, including superconducting qubits, ion traps, Rydberg atoms, photonic systems, and solid-state quantum dots.

The quantum hardware is implemented on these systems to enable the quantum computations. Each of these systems has unique properties that make them suitable for different types of quantum computations.

Superconducting qubits are tiny circuits that can carry an electric charge and can exist in multiple states at once. Ion traps use individual ions held in place by electromagnetic fields as qubits. Rydberg atoms are atoms in a highly excited state that can be used for quantum computations due to their strong interactions. Photonic systems use particles of light (photons) as qubits, while solid-state quantum dots use the spin of electrons in a small semiconductor dot as qubits.

The quantum hardware is implemented on these systems to perform the quantum computations. The choice of system would depend on the specific requirements of the quantum machine learning task.

In summary, Step 108 involves the implementation of the quantum hardware on a variety of systems, including superconducting qubits, ion traps, Rydberg atoms, photonic systems, and solid-state quantum dots. This step enables the quantum computations necessary for the quantum machine learning process.

Step 110 from Step 6 involves the provision of faster convergence and training, and better precision by the symmetric quantum circuit. This is manifested as the symmetric quantum circuit providing faster convergence and training, and better precision (Claim 14).

The component involved in this action is the symmetric quantum circuit. This refers to the quantum circuit that is constructed by the quantum circuit construction module and optimized by the optimization module. The symmetric quantum circuit is an equivariant variational quantum circuit, which is a specific type of quantum circuit that respects the symmetries of the dataset.

The symmetric quantum circuit provides faster convergence and training, and better precision. Convergence refers to the process of an optimization algorithm approaching an optimal solution. In the context of quantum machine learning, faster convergence means that the quantum circuit can reach an optimal solution more quickly. Training refers to the process of adjusting the parameters of the quantum circuit based on a training set to minimize a cost function. Faster training means that the quantum circuit can learn to perform a task more quickly. Better precision refers to the accuracy of the predictions made by the quantum circuit.

The symmetric quantum circuit provides faster convergence and training, and better precision to improve the performance of the quantum machine learning process. Faster convergence and training can make the quantum machine learning process more efficient, while better precision can make the results of the quantum machine learning process more accurate.

In terms of the mechanism of this action, the symmetric quantum circuit likely uses quantum algorithms and computational processes to provide faster convergence and training, and better precision. The specifics of these processes would depend on the nature of the quantum circuit, the optimization technique used, and the specific quantum machine learning task.

In summary, Step 110 involves the symmetric quantum circuit providing faster convergence and training, and better precision. This step improves the performance of the quantum machine learning process.

Step 112 from Step 6 involves the use of quantum machine learning in the implementation of the quantum circuits. This is manifested as the implementation of variational equivariant quantum circuits for quantum machine learning (Claim 20).

The component involved in this action is quantum machine learning. This refers to the application of quantum computing principles to machine learning tasks. Quantum machine learning can offer computational advantages over classical machine learning for certain types of tasks.

In this step, quantum machine learning is used to implement the quantum circuits. The quantum circuits are the equivariant variational quantum circuits that are constructed and optimized.

The use of quantum machine learning in the implementation of the quantum circuits is done to leverage the computational advantages of quantum computing. The quantum circuits are implemented to perform quantum computations that are relevant to the machine learning task.

In terms of the mechanism of this action, the implementation of the quantum circuits using quantum machine learning involves the use of quantum algorithms and computational processes that are designed for quantum machine learning tasks. The specifics of these processes would depend on the nature of the quantum circuits, the specific quantum machine learning task, and the quantum hardware on which the quantum circuits are implemented.

In summary, Step 112 involves the use of quantum machine learning in the implementation of the quantum circuits. This step leverages the computational advantages of quantum computing for machine learning tasks.

The Equivariant Quantum Circuit System, numbered as 200, is part of the quantum machine learning process. It leverages the symmetries of the dataset, leading to faster convergence and training, as well as better precision.

The system is composed of several key components. The first is the Data Ingestion Component (202), which processes input data from a data source. This involves reading classical data from a dataset and converting it into a format suitable for quantum computation.

The Quantum Circuit Builder (204) is another part of the system. It constructs a symmetric quantum circuit that respects the data characteristics on a series of quantum bits using symmetric quantum operations. This includes the construction of an equivariant variational quantum circuit, which is built using the symmetries of the dataset. This is further broken down into a sub-component, the Equivariant Circuit Constructor (204-a), which specifically handles the construction of the equivariant variational quantum circuit.

The Parameter Tuner (206) optimizes the circuit parameters to minimize a performance metric using an optimization technique. This involves using conjugate gradient descent or similar methods to fine-tune the parameters of the equivariant variational quantum circuit. The goal is to minimize a cost function for a training set, which helps improve the efficiency and accuracy of the quantum circuit.

The Prediction Generator (208) is responsible for generating output data over new input data. This involves making predictions over a new set of datapoints using the trained quantum circuit.

Finally, the Quantum Hardware Integrator (210) ensures that the quantum hardware can be implemented on various quantum systems. This includes superconducting qubits, ion traps, Rydberg atoms, photonic systems, and solid-state quantum dots. This component is for the physical implementation of the quantum circuit on various types of quantum hardware.

The Equivariant Quantum Circuit System (200) begins its operation with the Data Ingestion Component (202). This component handles the input data from a data source. It reads classical data from a dataset and converts it into a format suitable for quantum computation.

Once the data is prepared, the Quantum Circuit Builder (204) comes into play. This component constructs a symmetric quantum circuit that respects the data characteristics on a series of quantum bits using symmetric quantum operations. The construction of the circuit is done in such a way that it respects the relevant symmetries of the dataset. This is where the Equivariant Circuit Constructor (204-a) comes into play. This sub-component specifically handles the construction of the equivariant variational quantum circuit. The use of symmetries in the dataset to construct the circuit helps improve the efficiency and accuracy of the quantum circuit.

After the construction of the quantum circuit, the Parameter Tuner (206) optimizes the circuit parameters. This is done to minimize a performance metric using an optimization technique. The optimization module uses conjugate gradient descent or similar methods to fine-tune the parameters of the equivariant variational quantum circuit. The goal is to minimize a cost function for a training set, which helps improve the efficiency and accuracy of the quantum circuit.

Once the circuit parameters are optimized, the Prediction Generator (208) generates output data over new input data. This involves making predictions over a new set of datapoints using the trained quantum circuit.

Finally, the Quantum Hardware Integrator (210) ensures that the quantum hardware can be implemented on various quantum systems. This includes superconducting qubits, ion traps, Rydberg atoms, photonic systems, and solid-state quantum dots. This component is for the physical implementation of the quantum circuit on various types of quantum hardware.

In summary, the Equivariant Quantum Circuit System (200) works by processing input data, constructing a symmetric quantum circuit, optimizing circuit parameters, and generating output data. Each component and sub-component plays a role in this process, contributing to the system's efficiency and precision in quantum machine learning applications.

The Data Ingestion Component, numbered as 202, is a part of the Equivariant Quantum Circuit System. It plays a role in the initial stage of the quantum machine learning process. This component handles the input data from a data source. It reads classical data from a dataset and converts it into a format suitable for quantum computation. This step ensures that the data is in the right form to be processed by the quantum circuit.

The Data Ingestion Component (202) initiates the operation of the Equivariant Quantum Circuit System. This component handles the input data from a data source. It reads classical data from a dataset and converts it into a format suitable for quantum computation. This step is about reading the data and ensuring that the data is in the right form to be processed by the quantum circuit. The conversion of classical data into a format suitable for quantum computation is a key aspect of this component's function. This process is carried out under the condition that the data is classical and comes from a dataset. The method involves reading the data and then converting it into a suitable format. This is the first step in the process and sets the stage for the subsequent components of the system. The Data Ingestion Component (202) is thus a part of the system, setting the foundation for the quantum machine learning process.

The Quantum Circuit Builder, numbered as 204, is a part of the Equivariant Quantum Circuit System. It is involved in the construction of a symmetric quantum circuit that respects the data characteristics on a series of quantum bits using symmetric quantum operations. This includes the construction of an equivariant variational quantum circuit, which is built using the symmetries of the dataset.

This component is further broken down into a sub-component, the Equivariant Circuit Constructor (204-a), which specifically handles the construction of the equivariant variational quantum circuit. The use of symmetries in the dataset to construct the circuit helps improve the efficiency and accuracy of the quantum circuit. The Quantum Circuit Builder and its sub-component, the Equivariant Circuit Constructor, are parts of the system, contributing to the construction of the quantum circuit.

The Quantum Circuit Builder (204) is a part of the Equivariant Quantum Circuit System. This component constructs a symmetric quantum circuit that respects the data characteristics on a series of quantum bits using symmetric quantum operations. The construction of the circuit is done in such a way that it respects the relevant symmetries of the dataset. This is where the Equivariant Circuit Constructor (204-a) comes into play. This sub-component specifically handles the construction of the equivariant variational quantum circuit. The use of symmetries in the dataset to construct the circuit helps improve the efficiency and accuracy of the quantum circuit.

After the data is prepared by the Data Ingestion Component (202), the Quantum Circuit Builder (204) comes into play. This component constructs a symmetric quantum circuit that respects the data characteristics on a series of quantum bits using symmetric quantum operations. The construction of the circuit is done in such a way that it respects the relevant symmetries of the dataset. This is where the Equivariant Circuit Constructor (204-a) comes into play. This sub-component specifically handles the construction of the equivariant variational quantum circuit. The use of symmetries in the dataset to construct the circuit helps improve the efficiency and accuracy of the quantum circuit.

The Quantum Circuit Builder (204) and its sub-component, the Equivariant Circuit Constructor (204-a), play a role in the construction of the quantum circuit. The construction of the circuit is done in such a way that it respects the relevant symmetries of the dataset. The use of symmetries in the dataset to construct the circuit helps improve the efficiency and accuracy of the quantum circuit. This process is carried out under the condition that the data is classical and comes from a dataset. The method involves reading the data and then converting it into a suitable format. This is the first step in the process and sets the stage for the subsequent components of the system. The Quantum Circuit Builder (204) and its sub-component, the Equivariant Circuit Constructor (204-a), are thus a part of the system, setting the foundation for the quantum machine learning process.

The Parameter Tuner, numbered as 206, is a part of the Equivariant Quantum Circuit System. It is involved in optimizing the circuit parameters to minimize a performance metric using an optimization technique. This includes using conjugate gradient descent or similar methods to fine-tune the parameters of the equivariant variational quantum circuit. The goal is to minimize a cost function for a training set, which helps improve the efficiency and accuracy of the quantum circuit.

After the quantum circuit is constructed by the Quantum Circuit Builder (204) and its sub-component, the Equivariant Circuit Constructor (204-a), the Parameter Tuner (206) comes into play. This component optimizes the circuit parameters to minimize a performance metric using an optimization technique. The optimization module uses conjugate gradient descent or similar methods to fine-tune the parameters of the equivariant variational quantum circuit. The goal is to minimize a cost function for a training set, which helps improve the efficiency and accuracy of the quantum circuit. This process is carried out under the condition that the data is classical and comes from a dataset. The method involves reading the data and then converting it into a suitable format. This is the first step in the process and sets the stage for the subsequent components of the system. The Parameter Tuner (206) is thus a part of the system, setting the foundation for the quantum machine learning process.

The Prediction Generator, numbered as 208, is a part of the Equivariant Quantum Circuit System. It is responsible for generating output data over new input data. This involves making predictions over a new set of datapoints using the trained quantum circuit.

After the quantum circuit is constructed by the Quantum Circuit Builder (204) and its sub-component, the Equivariant Circuit Constructor (204-a), and the circuit parameters are optimized by the Parameter Tuner (206), the Prediction Generator (208) comes into play. This component generates output data over new input data. This involves making predictions over a new set of datapoints using the trained quantum circuit. This process is carried out under the condition that the data is classical and comes from a dataset. The method involves reading the data and then converting it into a suitable format. This is the final step in the process and sets the stage for the subsequent components of the system. The Prediction Generator (208) is thus a part of the system, setting the foundation for the quantum machine learning process.

The Quantum Hardware Integrator, numbered as 210, is a part of the Equivariant Quantum Circuit System. It ensures that the quantum hardware can be implemented on various quantum systems. This includes superconducting qubits, ion traps, Rydberg atoms, photonic systems, and solid-state quantum dots. This component is for the physical implementation of the quantum circuit on various types of quantum hardware.

After the quantum circuit is constructed by the Quantum Circuit Builder (204) and its sub-component, the Equivariant Circuit Constructor (204-a), the circuit parameters are optimized by the Parameter Tuner (206), and the output data is generated by the Prediction Generator (208), the Quantum Hardware Integrator (210) comes into play. This component ensures that the quantum hardware can be implemented on various quantum systems. This includes superconducting qubits, ion traps, Rydberg atoms, photonic systems, and solid-state quantum dots. This process is carried out under the condition that the data is classical and comes from a dataset. The method involves reading the data and then converting it into a suitable format. This is the final step in the process and sets the stage for the subsequent components of the system. The Quantum Hardware Integrator (210) is thus a part of the system, setting the foundation for the quantum machine learning process.

## Claims

1. A system for implementing symmetric quantum circuits, comprising:
a data processing module for processing input data from a data source;
a quantum circuit construction module for constructing a symmetric quantum circuit respecting data characteristics on a series of quantum bits using symmetric quantum operations;
an optimization module for optimizing circuit parameters to minimize a performance metric using an optimization technique;
an output generation module for generating output data over new input data.

2. The system of claim 1, wherein the data processing module reads classical data from a dataset.

3. The system of claim 2, wherein the symmetric quantum circuit construction module builds an equivariant variational quantum circuit.

4. The system of claim 3, wherein the optimization module uses conjugate gradient descent or similar to fine-tune the parameters of the equivariant variational quantum circuit.

5. The system of claim 4, wherein the output generation module makes predictions over a new set of datapoints.

6. The system of claim 1, wherein the quantum hardware can be implemented on superconducting qubits, ion traps, Rydberg atoms, photonic systems, and solid-state quantum dots.

7. The system of claim 1, wherein the symmetric quantum circuit provides faster convergence and training, better precision.

8. A method for implementing symmetric quantum circuits, comprising:
processing input data from a data source;
constructing a symmetric quantum circuit respecting data characteristics on a series of quantum bits using symmetric quantum operations;
optimizing circuit parameters to minimize a performance metric using an optimization technique;
generating output data over new input data.

9. The method of claim 8, wherein the input data is classical data from a dataset.

10. The method of claim 9, wherein the quantum circuit is an equivariant variational quantum circuit.

11. The method of claim 10, wherein the optimization technique is conjugate gradient descent or similar that fine-tunes the parameters of the equivariant variational quantum circuit.

12. The method of claim 11, wherein the output data is predictions over a new set of datapoints.

13. The method of claim 8, wherein the quantum hardware can be implemented on superconducting qubits, ion traps, Rydberg atoms, photonic systems, and solid-state quantum dots.

14. The method of claim 8, wherein the symmetric quantum circuit provides faster convergence and training, better precision.

15. The method of claim 8, further comprising using the symmetries of the dataset to build the quantum circuit.

16. The method of claim 8, further comprising using a training set for the optimization of the quantum circuit.

17. The method of claim 8, further comprising using a cost function for the optimization of the quantum circuit.

18. The method of claim 8, further comprising using quantum gates in the construction of the quantum circuit.

19. The method of claim 8, further comprising using a series of qubits in the construction of the quantum circuit.

20. The method of claim 8, further comprising using quantum machine learning in the implementation of the quantum circuits.
